Europäisches Patentamt

European Patent Office

Office européen des brevets

(11) Publication number: **0 212 898 B1**

## EUROPEAN PATENT SPECIFICATION

(45) Date of publication of patent specification: **30.12.92** (51) Int. Cl.⁵: **H03M 1/54**

(21) Application number: **86305966.3**

(22) Date of filing: **01.08.86**

(54) **Analog-to-digital converter.**

(30) Priority: **13.08.85 US 765405**

(43) Date of publication of application:
**04.03.87 Bulletin 87/10**

(45) Publication of the grant of the patent:
**30.12.92 Bulletin 92/53**

(84) Designated Contracting States:
**DE FR GB IT SE**

(56) References cited:
**FR-A- 2 385 264**
**US-A- 3 414 898**
**US-A- 3 469 255**
**US-A- 4 191 942**

(73) Proprietor: **INTERNATIONAL CONTROL AUTO-
MATION FINANCE S.A.**
**16 Rue des Bains**
**Ville de Luxembourg(LU)**

(72) Inventor: **Whitford, Rowland Edgar**
**6230 Ravenna Road**
**Painesville Ohio 44077(US)**
Inventor: **Bastijanic, Edward**
**7064 Bristlewood**
**Concord Ohio 44077(US)**

(74) Representative: **Cotter, Ivan John et al**
**D. YOUNG & CO. 10 Staple Inn**
**London WC1V 7RD(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

This invention relates to analog-to-digital converters.

Signal conversion of an analog signal to a digital signal for digital processing in low power applications, such as pressure transducers, is normally accomplished by a voltage to frequency (V/F) converter. Commercially available A/D converters are not utilised due to their excessive power consumption. There are no commercially available integrated circuits for analog to digital conversion that are of sufficiently low power, that is less than 12 mW, to run from a 4-20 mA current loop.

While V/F converters can be utilised, they are relatively slow in response time and low in accuracy. The slow conversion of the V/F converter results from the need for a counting interval that is at least as long as the period for the lowest frequency signal. The response time is a fixed value regardless of the frequency of the signal. This means that a microprocessor used in conjunction with the V/F converter will be tied up during this conversion time. This limits the overall response of the pressure transducer. With regard to accuracy, a moderate-precision V/F circuit has an accuracy range of about 0.4% to 0.1%. To obtain a high-precision V/F circuit with an accuracy range of 0.03% to 0.01% requires additional components which result in greater power consumption and higher cost.

A converter which operates at low power consumption and with high accuracy would be particularly useful for a two-wire 4-20 mA current loop.

Two-wire analog transmission systems are known. Such systems include a transmitter which is connected to a power supply by two wires which form a current loop. The transmitter includes, as at least one of its features, a transducer which senses a condition such as pressure or temperature. This condition is known as a process variable (PV).

The power supply is connected to the two wires to close the current loop. It is also known to provide a resistor in the current loop. The transmitter amplifies the signal from its transducer and this amplified signal is used to draw a certain current from the power supply which is proportional or otherwise related to the process variable. It is also known to draw from a minimum of 4mA to a maximum of 20mA. The current between 4 and 20mA passes through the resistor to produce a voltage drop across the resistor. This voltage drop can be measured to give a value for the process variable.

It is noted that the 4mA minimum current is required to energise the circuitry of the transmitter. Any excess current above this 4mA level is taken as a value which can be used to determine the process variable.

It is known that such 4-20mA two-wire systems have an accuracy which is limited to around 0.1% at best. These systems are also essentially unidirectional with the transmitter being essentially uncontrolled and transmitting continuously.

US Patent No. US-A-3 414 898 discloses a converter for converting an analog signal to a series of pulses, the converter comprising:

a first capacitor that can be connected to receive an analog signal so as to be charged to a charge level which is equal to the analog signal level;

an output circuit connectable to the first capacitor, the output circuit including a second capacitor and a constant current source for discharging the second capacitor;

switching means for connecting the analog signal and the output circuit one at a time to the first capacitor for charging the first capacitor to its charge level and for transferring the charge on the first capacitor to the second capacitor to enable the second capacitor later to be discharged by the constant current source during a discharging period;

pulse generating means connected to the output circuit for generating a pulse having a duration equalling the discharging period, the pulse generating means comprising a multivibrator which is set at a time subsequent to transfer of the charge to the second capacitor to start said pulse, which is applied to a gate to enable discharge of the second capacitor to occur, and a trigger circuit which is responsive to discharge to a predetermined level having occurred to reset the multivibrator whereby said pulse is ended; and

another gate enabled during said pulse to pass pulses from an oscillator to a counter, the pulses from the oscillator constituting said series of pulses.

According to the invention there is provided a converter for converting a pair of analog signals to a pulse, the converter comprising:

a capacitor;

an input circuit that comprises a pair of amplifiers interconnected to form a high impedance differential amplifier for receiving the analog signals and producing a differential signal across a pair of outputs, and a first pair of switches for connecting the outputs of the high impedance differential amplifier across the capacitor to charge the capacitor to a charge level which is proportional to the differential signal;

an output circuit including a constant current source and a second pair of switches for connecting the constant current source to the capacitor for discharging the capacitor from its charge level to a selected low level during a discharging period;

switching control means arranged to operate the first and second pairs of switches such that the outputs of the high impedance differential amplifier, on the one hand, and the constant current source, on the other hand, are connected one at a time to the capacitor for charging the capacitor to its charge level and for discharging the capacitor to the selected low level, the switching control means being operative to connect the capacitor to the high impedance differential amplifier for a sufficient time to reach the charge level and to connect the capacitor to the constant current source for a time longer than the discharging period; and

pulse generating means connected to the output circuit for generating a pulse having a duration equalling the discharging period.

A preferred form of converter embodying the present invention and described hereinbelow utilises a voltage to pulse (V/P) principle which operates with less than 3 mW of power. The pulse duration of an output signal from the converter is proportional to an analog input signal. The conversion time and accuracy of the V/P converter, with minimal components for low power dissipation, is an improvement over known V/F converters. Further improvements in accuracy and conversion time are obtained by using input auto-ranging. By utilising such a V/P technique, an associated microprocessor will be tied up only for the pulse duration time period. The low power consumption is a result of the minimal number of components needed to implement the V/P circuit and the utilisation of low power integrated circuits. Even with this minimal component count, the average tested accuracy of the V/P circuit is +0.03%. The preferred voltage-to-pulse converter has low power consumption, high accuracy and is simple in design, rugged in construction and economical to manufacture.

The invention will now be further described, by way of illustrative and non-limiting example, with reference to the accompanying drawings, in which:

Figure 1 is a schematic block diagram of one voltage-to-pulse converter embodying the invention;

Figure 2 is a graph showing a pulse train which can be generated by the converter;

Figure 3 is a graph, similar to Figure 2, showing a pulse having a different duty cycle which can be generated by the converter when it receives a different lower analog signal; and

Figure 4 is a schematic block diagram showing another converter embodying the invention.

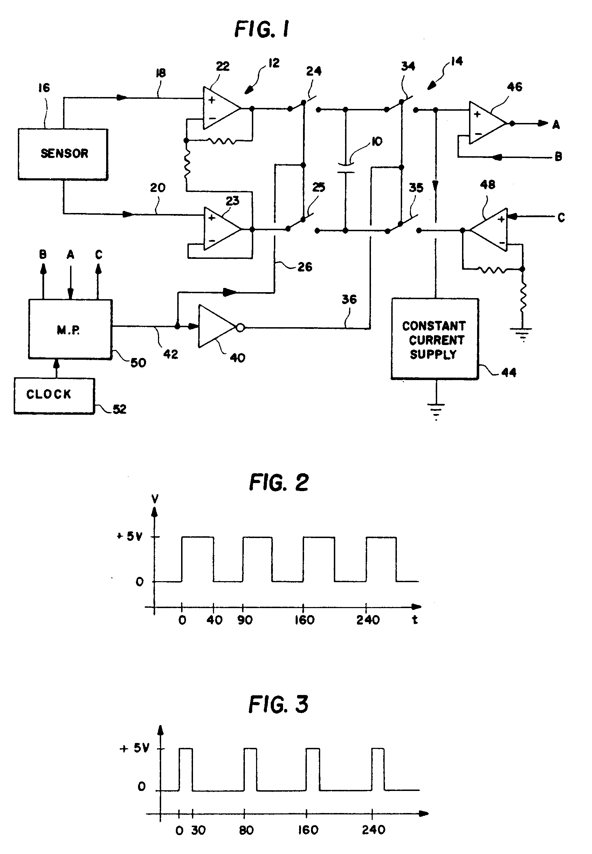

Figure 1 shows a voltage-to-pulse converter which includes a switching capacitor 10 that is connectable selectively to an input circuit 12 and an output circuit 14. A sensor 16, such as a differential strain gauge transducer, has a pair of outputs at 18 and 20 which carry different analog voltages which correspond to a differential in pressure being measured by the sensor 16. Each output 18,20 is connected to a respective operational amplifier 22 and 23, which amplifiers are connected together to form a high input impedance differential amplifier. In addition to the amplifiers 22 and 23, the input circuit 12 includes a pair of electronic input switches 24 and 25 which can be closed simultaneously by a signal on a line 26. By applying an appropriate logical signal on the line 26, both the switches 24 and 25 are closed. The analog signal on the lines 18 and 20 is thus applied, via the operational amplifiers, to the switching capacitor 10. As long as the switches 24,25 are closed for a long enough charging period, the capacitor 10 will be charged up to a level which is proportional to the differential signal on the lines 18 and 20.

The output circuit 14 includes a pair of output switches 34 and 35 which can be closed simultaneously by a line 36. The line 36 is connected to an output of an inverter 40. A line 42 is connected to an input of the inverter 40 and also directly to the line 26. In this way, a high or logical 1 signal applied to the line 42 will cause the switches 24,25 to close while the switches 34,35 are held open. Conversely if a low or logical 0 signal is applied to the line 42, the switches 24,25 are open and the switches 34,35 are closed.

The output circuit 14 includes a constant current supply or source 44 which, with the switches 34,35 closed, causes the switching capacitor 10 to discharge at a fixed rate. The time it takes the capacitor 10 to discharge from its charged level to a selected discharged or low level is utilised to generate a pulse having a width which is equal to that discharge period. The pulse is generated by a comparator 46 which can be in the form of a differential amplifier having a positive (non-inverting) input connected to one side of the capacitor 10 and a negative (inverting) input connected to a terminal B. The terminal B receives a trip point voltage which determines the level at which the comparator 46 will output a signal on an output terminal A thereof.

The discharging time for the capacitor 10 can also be modified by utilising a bias input which is applied to a terminal C of an amplifier 48. The terminal C can be used for reference and auto-ranging to compensate for factors which might cause the sensor 16 to drift, such as temperature and other pressure conditions.

The terminals A, B and C are connected to a microprocessor 50 which is connected to a clock 52. With the aid of the clock 52, the microprocessor 50 outputs signals onto the line 42. In this way, pulse trains similar to those shown in Figures 2 and 3 can be generated. Both Figures 2 and 3 assume a pulse width or spacing of 80 ms. It is always assumed that the width of the pulses is at least as great as the maximum time it takes the capacitor 10 to be fully charged to its charged level, and fully discharged to the selected low level.

Figure 2 shows an example where the generated pulse is on for one-half of the pulse train period. The capacitor 10 is assumed already to have been charged to its charge level by the differential signal on the lines 18 and 20. At a time t = 0, it is assumed that the microprocessor 50 generates a logical 0 signal on the line 42. This closes the switches 34,35 and opens the switches 24,25. The capacitor 10 then immediately begins to discharge via the constant current source 44. As long as this discharge takes place, the comparator 46 outputs a high voltage signal, shown as 5 volts in Figure 2. This continues until 40 ms into the first pulse, whereupon the level at the positive input of the comparator 46 is equal to the trip point voltage applied to the terminal B by the microprocessor 50. At this point the output of the comparator 46 drops to 0 as shown in Figure 2. As soon as the microprocessor 50 senses, over its input terminal A, that the pulse has dropped to 0, it may immediately generate a logical 1 signal on the line 42 to close the switches 24,25 and open the switches 34,35. Alternatively, an arbitrary time period can be taken which assumes sufficient time has been provided for the discharge of the capacitor 10. Enough time must be provided for the capacitor 10 again to be charged to its charge level by the differential signal on the lines 18 and 20 so that at t = 80 ms a new pulse can be generated.

Figure 3 shows the case where there is a lower differential signal on the lines 18 and 20 and thereby a correspondingly shorter pulse width.

The converter described above thus enables pulses having a variable duty cycle to be generated, the duty cycle being a digital representation of the analog signal.

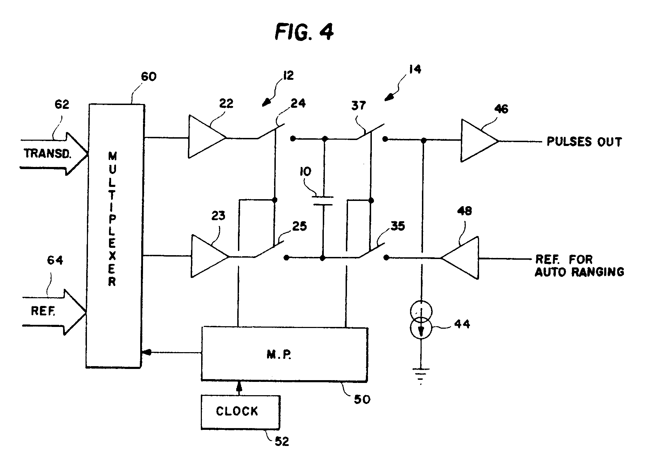

Converters embodying the invention can be utilised with a 4-20 mA current loop where maximum power dissipation is limited to 48 mW. As shown in Figure 4, which illustrates another embodiment of the invention, a differential input multiplexer 60 is used with a plurality of inputs 62 from a plurality of transducers, and a plurality of inputs 64 which can be used for auto-ranging. The four inputs of the multiplexer 60 can be dedicated for the transducer inputs 62 and four other inputs for the inputs 64. The multiplexer 60 sequentially selects one of the eight available inputs at a time for the amplifiers 22 and 23 of the input circuit 12. In Figure 4, the same reference numerals are utilised to designate same or similar parts as in Figure 1.

The multiplexer 60 is controlled by the microprocessor 50. The switches 24,25 and 34,35 are also controlled by the microprocessor 50, with priming established by the clock 52, to charge and discharge the capacitor 10. The comparator 46 generates output pulses while the amplifier 48 processes the reference signal for auto-ranging.

As with the embodiment of Figure 1, a constant current supply or source 44 is utilised for discharging the capacitor 10 at constant rate to establish the duty cycle for the output pulses.

**Claims**

1. A converter for converting a pair of analog signals to a pulse, the converter comprising:

a capacitor (10);

an input circuit (12) that comprises a pair of amplifiers (22, 23) interconnected to form a high impedance differential amplifier for receiving the analog signals and producing a differential signal across a pair of outputs, and a first pair of switches (24, 25) for connecting the outputs of the high impedance differential amplifier across the capacitor (10) to charge the capacitor to a charge level which is proportional to the differential signal;

an output circuit (14) including a constant current source (44) and a second pair of switches (34, 35) for connecting the constant current source (44) to the capacitor (10) for discharging the capacitor (10) from its charge level to a selected low level during a discharging period;

switching control means (50, 40) arranged to operate the first and second pairs of switches (24, 25; 34, 35) such that the outputs of the high impedance differential amplifier, on the one hand, and the constant current source (44), on the other hand, are connected one at a time to the capacitor (10) for charging the capacitor to its charge level and for discharging the capacitor to the selected low level, the switching control means being operative to connect the capacitor to the high impedance differential amplifier for a sufficient time to reach the charge level and to connect the capacitor (10) to the constant current source (44) for a time longer than the discharging period; and

pulse generating means connected to the output circuit (14) for generating a pulse having a duration equalling the discharging period.

2. A converter according to claim 1, wherein the pulse generating means comprises a comparator (46) having one input connectable to one side of the capacitor (10) via the output circuit (14) and another input connected to a reference voltage for establishing the selected low level of charge for the capacitor.

3. A converter according to claim 1 or claim 2, wherein the switching control means comprises a microprocessor (50), the first pair of switches (24, 25) comprises a pair of electronic switches controllable by the microprocessor (50), and the second pair of switches (34, 35) comprises a pair of electronic switches controllable by the microprocessor.

**Patentansprüche**

1. Wandler zum Umwandeln eines Paares von analogen Signalen in einen Impuls, wobei der Wandler aufweist:

   einen Kondensator (10),

   einen Eingangsschaltkreis (12), weicher ein Paar von Verstärkern (22, 23) aufweist, die so miteinander verbunden sind, daß sie einen Differenzverstärker mit hoher Impendanz bilden, um die Analogsignale aufzunehmen und ein Differenzsignal an einem Paar von Ausgängen zu erzeugen, sowie ein Paar von Schaltern (24, 25) aufweist für den Anschluß der Ausgänge des Differenzverstärkers mit hoher Impedanz an den Kondensator (10), um den Kondensator auf ein Ladungsniveau aufzuladen, welches proportional zu dem Differenzsignal ist,

   einen Ausgangsschaltkreis (14), der eine Konstantstromquelle (44) und ein zweites Paar von Schaltern (34, 35) einschließt, um die Konstantstromquelle (44) an den Kondensator (10) anzuschließen, um den Kondensator (10) von seinem Ladungsniveau auf ein ausgewähltes niedriges Niveau während einer Entladezeit zu entladen,

   eine Schaltsteuereinrichtung (50, 40), welche so angelegt ist, daß sie das erste und das zweite Paar von Schaltem (24, 25; 34, 35) so betätigt, daß die Ausgänge des Differerzverstärkers mit hoher Impedanz einerseits und die Konstantstromquelle (44) andererseits jeweils getrennt (nacheinander) mit dem Kondensator (10) verbunden werden, um den Kondensator auf sein Ladungsniveau aufzuladen und um ihn auf das zweite niedrige Niveau zu entladen, wobei die Schaltsteuereinrichtung so betreibbar ist, daß sie den Kondensator für ausreichende Zeit an den Differenzverstärker mit hoher Impedanz anschließt, so daß er das Ladungsniveau erreicht, und daß der Kondensator (10) für eine Zeitdauer an die Konstantstromquelle (44) angeschlossen wird, die länger ist als die Entladedauer, und

   eine Impulserzeugungseinrichtung, welche mit dem Ausgangsschaltkreis (14) verbunden ist, um einen Impuls zu erzeugen, der eine Zeitdauer hat, welche gleich der Entladedauer ist.

2. Wandler nach Anspruch 1,wobei die Impulserzeugungseinrichtung einen Komparator (46) aufweist, dessen einer Anschluß mit einer Seite des Kondensators (10) über den Ausgangsschaltkreis (4) verbindbar ist und dessen anderer Eingang mit einer Referenzspannung für die Bereitstellung des ausgewählten niedrigen Ladungsniveaus des Kondensators verbunden ist.

3. Wandler nach Anspruch 1 oder 2, wobei die Schaltsteuereinrichtung einen Mikroprozessor (50) aufweist, das erste Paar von Schaltern (24, 25) ein Paar von elektronischen Schaltern aufweist, die von dem Mikroprozessor steuerbar sind, und das zweite Paar von Schaltern (34, 35) ein Paar von elektronischen Schaltern aufweist, welche von dem Mikroprozessor steuerbar sind.

**Revendications**

1. Convertisseur permettant de convertir deux signaux analogiques en une impulsion, le convertisseur comportant:

   un condensateur (10);

   un circuit d'entrée (12) constitué d'une paire d'amplificateurs (22, 23) interconnectés de manière à former un amplificateur différentiel à haute impédance recevant les signaux analogiques et fournissant un signal différentiel sur une paire de sorties, et une première paire d'interrupteurs (24, 25) reliant les sorties de l'amplificateur différentiel à haute impédance au condensateur (10), afin de charger le condensateur à un niveau de charge proportionnel au signal différentiel;

   un circuit de sortie (14) comportant une source de courant constant (44) et une seconde paire d'interrupteurs (34, 35) reliant la source de courant constant (44) au condensateur (10 afin de décharger le condensateur (10) de son niveau de charge jusqu'à un niveau bas choisi, pendant le temps d'une durée de décharge;

   un moyen de contrôle de la commutation (50, 40) commandant la première et la seconde paire d'interrupteurs (24, 25; 34, 35) de telle manière que les sorties de l'amplificateur différentiel à haute impédance d'une part, et la source de courant constant (44) d'autre part, soient reliées alternativement au condensateur (10) afin de charger le condensateur jusqu'au niveau de charge et de décharger le condensateur au niveau bas choisi, le moyen contrôlant la commutation reliant le condensateur à l'amplificateur différentiel à haute impédance pendant une durée suffisamment longue pour pouvoir atteindre le niveau de charge et pour relier le condensateur (10) à la source de courant constant (44) pendant un temps supérieur à la durée de décharge; et

un moyen de génération des impulsions relié au circuit de sortie (14) et pouvant générer une impulsion égale à la durée de décharge.

2. Convertisseur selon la revendication 1, caractérisé en ce que le moyen de génération d'impulsions comporte un comparateur (46) dont l'une des entrées peut être reliée à une borne d'un condensateur (10) à travers le circuit de sortie (14) et une autre entrée reliée à une tension de référence afin de déterminer le niveau bas de charge choisi pour le condensateur.

3. Convertisseur selon la revendication 1 ou 2, caractérisé en ce que le moyen de contrôle de la commutation comporte un microprocesseur (50), la première paire d' interrupteurs (24, 25) comportant deux interrupteurs électroniques commandés par le microprocesseur (50), et la seconde paire d'interrupteurs (34, 35) comportant deux interrupteurs électroniques commandés par le microprocesseur.

# FIG. 1

# FIG. 2

# FIG. 3

# FIG. 4